(19) **Europäisches Patentamt / European Patent Office / Office européen des brevets**

(11) **EP 4 050 827 A1**

(12) **EUROPEAN PATENT APPLICATION**
published in accordance with Art. 153(4) EPC

(43) Date of publication:
**31.08.2022 Bulletin 2022/35**

(21) Application number: **19945023.0**

(22) Date of filing: **13.09.2019**

(51) International Patent Classification (IPC):
**H04L 1/08** (2006.01)     **H03M 13/23** (2006.01)
**H03M 13/43** (2006.01)

(52) Cooperative Patent Classification (CPC):
**H04B 1/12; H03M 13/23; H03M 13/3769;**
**H03M 13/45; H04B 1/16; H04L 1/0045;**
**H04L 1/0059; H04L 1/0061; H04L 1/08**

(86) International application number:
**PCT/JP2019/036188**

(87) International publication number:
**WO 2021/049024 (18.03.2021 Gazette 2021/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **MITSUBISHI ELECTRIC CORPORATION**
**Chiyoda-ku**
**Tokyo 100-8310 (JP)**

(72) Inventors:
• **NAKAJIMA, Akinori**
**Tokyo 1008310 (JP)**
• **HIGASHINAKA, Masatsugu**
**Tokyo 1008310 (JP)**

(74) Representative: **Pfenning, Meinig & Partner mbB**
**Patent- und Rechtsanwälte**
**Theresienhöhe 11a**
**80339 München (DE)**

(54) **TRANSMISSION DEVICE, RECEPTION DEVICE, COMMUNICATION SYSTEM, CONTROL CIRCUIT, COMMUNICATION METHOD, AND STORAGE MEDIUM**

(57)     A transmitting apparatus (2) includes: a transmitting module (22) that is a fixed circuit whose internal processing procedure cannot be changed, and performs modulation processing on transmission data; and an external transmission control unit (21) that includes a transmitting module controller (211) to control the transmitting module (22) according to redundancy encoding processing for conversion into a multilevel sequence on the receiving side and includes a redundancy encoder (214) to redundantly encode transmission data using an error-correction encoded sequence, and that provides a redundant encoded sequence obtained by redundantly encoding the transmission data to the transmitting module (22).

FIG.2

## EP 4 050 827 A1

**Description**

Field

The present invention relates to a transmitting apparatus, a receiving apparatus, a communication system, a control circuit, a communication method, and a storage medium that use a fixed circuit whose internal processing procedure cannot be changed.

Background

Functions in common use are sometimes provided as general-purpose modules. A general-purpose module is a fixed circuit whose internal processing procedure cannot be changed. In the communication field, frequently used functions such as high-frequency processing functions and digital modulation and demodulation processing functions are provided as modules. For example, Patent Literature 1 discloses a demodulation method for frequency-shift keying (FSK) signals. For functions with a high frequency of use such as modulation processing and demodulation processing, general-purpose modules can be used to reduce the time and effort of duplicate development.

Citation List

Patent Literature

Patent Literature 1: Japanese Patent No. 4161883

Summary

Technical Problem

However, when a general-purpose module is used, the internal processing procedure of the circuit cannot be changed. Consequently, in wireless communication, in which error-correction coding is typically performed, using a module whose internal processing procedure cannot be changed has a problem in that it becomes difficult to increase the probability that transmission data can be correctly restored in response to a request of a system, for example.
The present invention has been made in view of the above, and an object thereof is to provide a transmitting apparatus capable of increasing the probability that transmission data can be correctly restored.

Solution to Problem

To solve the above-described problems and achieve the object, a transmitting apparatus according to the present invention includes: a transmitting module that is a fixed circuit whose internal processing procedure is not able to be changed, the transmitting module performing modulation processing on transmission data; and an external transmission control unit including a transmitting module controller to control the transmitting module according to redundancy encoding processing for conversion into a multilevel sequence on a receiving side, and a redundancy encoder to redundantly encode transmission data using an error-correction encoded sequence, the external transmission control unit providing a redundant encoded sequence obtained by redundantly encoding the transmission data to the transmitting module.

Advantageous Effects of Invention

The transmitting apparatus according to the present invention achieves the effect of being able to increase the probability that transmission data can be correctly restored.

Brief Description of Drawings

FIG. 1 is a diagram illustrating a configuration of a communication system according to a first embodiment of the present invention.
FIG. 2 is a diagram illustrating a functional configuration of a transmitting apparatus illustrated in FIG. 1.
FIG. 3 is a diagram for explaining the function of a redundancy encoder illustrated in FIG. 2.

FIG. 4 is a diagram illustrating a functional configuration of a receiving apparatus illustrated in FIG. 1.

FIG. 5 is a diagram for explaining the processing of a redundancy decoder illustrated in FIG. 4.

FIG. 6 is a diagram illustrating dedicated hardware for implementing the functions of the transmitting apparatus and the receiving apparatus illustrated in FIG. 1.

FIG. 7 is a diagram illustrating a configuration of a control circuit for implementing the functions of the transmitting apparatus and the receiving apparatus illustrated in FIG. 1.

FIG. 8 is a diagram illustrating a functional configuration of a transmitting apparatus according to a second embodiment of the present invention.

FIG. 9 is a diagram for explaining the function of an error-correction encoder illustrated in FIG. 8.

FIG. 10 is a diagram for explaining the function of a redundancy encoder illustrated in FIG. 8.

FIG. 11 is a diagram for explaining the effect of the redundancy encoder illustrated in FIG. 8.

FIG. 12 is a diagram illustrating a functional configuration of a receiving apparatus according to the second embodiment of the present invention.

FIG. 13 is a diagram illustrating a functional configuration of a transmitting apparatus according to a third embodiment of the present invention.

FIG. 14 is a diagram illustrating a functional configuration of a receiving apparatus according to the third embodiment of the present invention.

FIG. 15 is a diagram for explaining the functions of a zero insertion unit and a redundancy decoder illustrated in FIG. 14.

FIG. 16 is a diagram illustrating a functional configuration of a receiving apparatus according to a fourth embodiment of the present invention.

FIG. 17 is a diagram illustrating a functional configuration of a receiving apparatus according to a first modification of the fourth embodiment of the present invention.

FIG. 18 is a diagram illustrating a functional configuration of a receiving apparatus according to a second modification of the fourth embodiment of the present invention.

FIG. 19 is a diagram for explaining the function of a redundancy decoder illustrated in FIG. 18.

FIG. 20 is a diagram illustrating a functional configuration of a transmitting apparatus according to a third modification of the fourth embodiment of the present invention.

Description of Embodiments

Hereinafter, a transmitting apparatus, a receiving apparatus, a communication system, a control circuit, a communication method, and a storage medium according to embodiments of the present invention will be described in detail with reference to the drawings. Note that the embodiments are not intended to limit the invention.

First Embodiment.

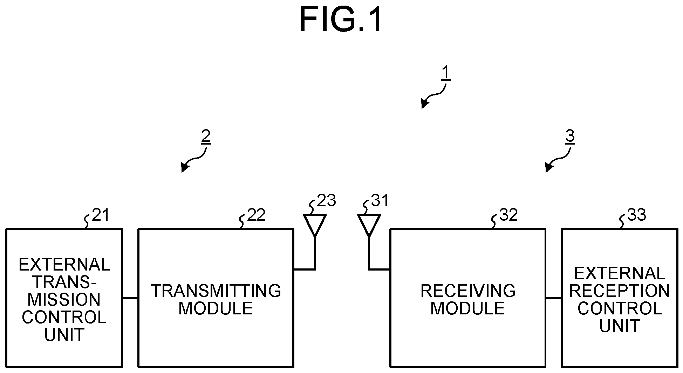

FIG. 1 is a diagram illustrating a configuration of a communication system 1 according to a first embodiment of the present invention. The communication system 1 includes a transmitting apparatus 2 and a receiving apparatus 3. The transmitting apparatus 2 includes an external transmission control unit 21, a transmitting module 22, and a transmitting antenna 23. The receiving apparatus 3 includes a receiving antenna 31, a receiving module 32, and an external reception control unit 33.

The transmitting module 22 and the receiving module 32 are fixed circuits whose internal processing procedures cannot be changed. The fixed circuits are, for example, general-purpose modules in which functions commonly used in many devices are packaged.

The external transmission control unit 21 has the function of controlling the transmitting module 22 from the outside of the transmitting module 22 and the function of providing transmission data to the transmitting module 22. The transmitting module 22 performs transmission processing on transmission data provided from the external transmission control unit 21 to generate a transmission signal. The transmitting module 22 transmits the transmission signal from the transmitting antenna 23. The receiving antenna 31 receives the transmission signal transmitted by the transmitting apparatus 2. The receiving module 32 performs reception processing on a reception signal received by the receiving antenna 31 to extract reception data. The external reception control unit 33 has the function of controlling the receiving module 32 from the outside of the receiving module 32 and the function of processing reception data provided from the receiving module 32.

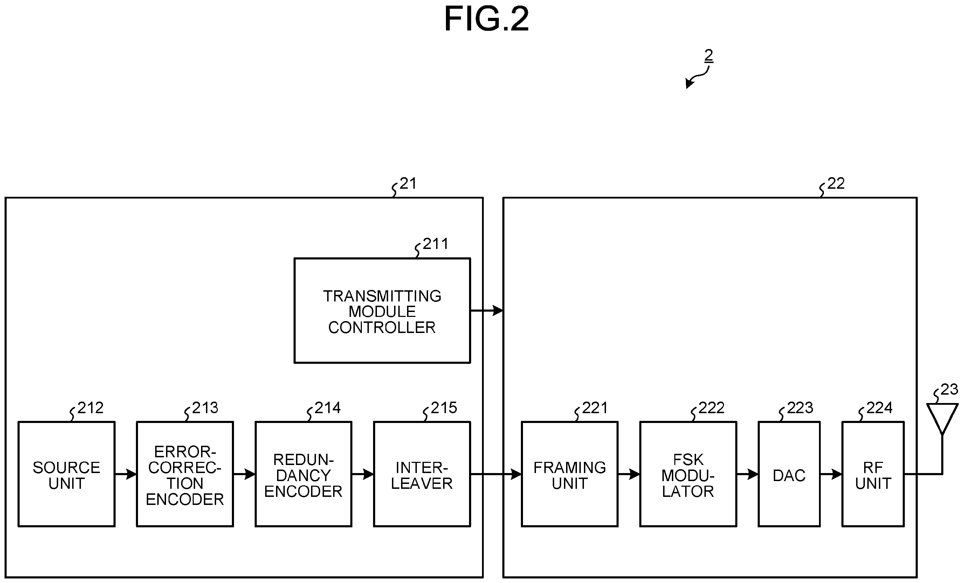

FIG. 2 is a diagram illustrating a functional configuration of the transmitting apparatus 2 illustrated in FIG. 1. The external transmission control unit 21 of the transmitting apparatus 2 is a circuit different from the transmitting module 22. The external transmission control unit 21 includes a transmitting module controller 211, a source unit 212, an error-correction encoder 213, a redundancy encoder 214, and an interleaver 215.

The transmitting module controller 211 controls the transmitting module 22 according to redundancy encoding processing for conversion into a multilevel sequence on the receiving side. For example, the transmitting module controller 211 instructs the transmitting module 22 on a carrier frequency to be used by the transmitting module 22. The source unit 212 outputs transmission data to the error-correction encoder 213. The error-correction encoder 213 performs error-correction coding on the transmission data. Specifically, the error-correction encoder 213 performs convolutional encoding on an information bit sequence of the transmission data. The error-correction encoder 213 outputs the processed convolutionally encoded sequence to the redundancy encoder 214. The redundancy encoder 214 redundantly encodes the convolutionally encoded sequence that is an error-correction encoded sequence.

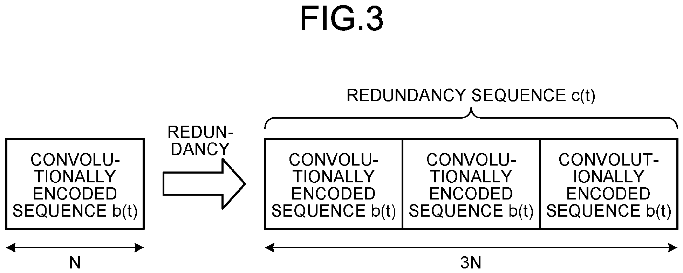

FIG. 3 is a diagram for explaining the function of the redundancy encoder 214 illustrated in FIG. 2. The redundancy encoder 214 provides redundancy of the convolutionally encoded sequence $b(t)$ output from the error-correction encoder 213. Specifically, the redundancy encoder 214 copies each bit of the convolutionally encoded sequence $b(t)$ for a predetermined number of repetitions nosq to generate a redundancy sequence $c(t)$ in which the convolutionally encoded sequence $b(t)$ is repeated for the number of repetitions nosq. In FIG. 3, the sequence length of the convolutionally encoded sequence $b(t)$ is N, the number of repetitions nosq=3, and thus the sequence length of the redundancy sequence $c(t)$ is 3N. The redundancy encoder 214 outputs the generated redundancy sequence $c(t)$ to the interleaver 215.

Return to the description of FIG. 2. The interleaver 215 interleaves the redundancy sequence $c(t)$ and outputs the processed redundancy sequence $c(t)$ to the transmitting module 22.

The transmitting module 22 of the transmitting apparatus 2 includes a framing unit 221, a FSK modulator 222, a digital-to-analog converter (DAC) 223, and a radiofrequency (RF) unit 224. The transmitting module 22 has both the function of a transmitting circuit and the function of a modulation circuit.

The framing unit 221 performs predetermined framing processing on the redundancy sequence $c(t)$ of the transmission data and then outputs the data to the FSK modulator 222. The FSK modulator 222 performs predetermined FSK modulation processing on the redundancy sequence $c(t)$ of the transmission data after the framing processing, to generate a digital transmission signal. The FSK modulator 222 outputs the generated digital transmission signal to the DAC 223. The DAC 223 converts the digital transmission signal into an analog signal. The DAC 223 outputs the converted transmission signal to the RF unit 224. The RF unit 224 converts the frequency of the transmission signal output from the DAC 223 into a set carrier frequency and transmits the transmission signal from the transmitting antenna 23.

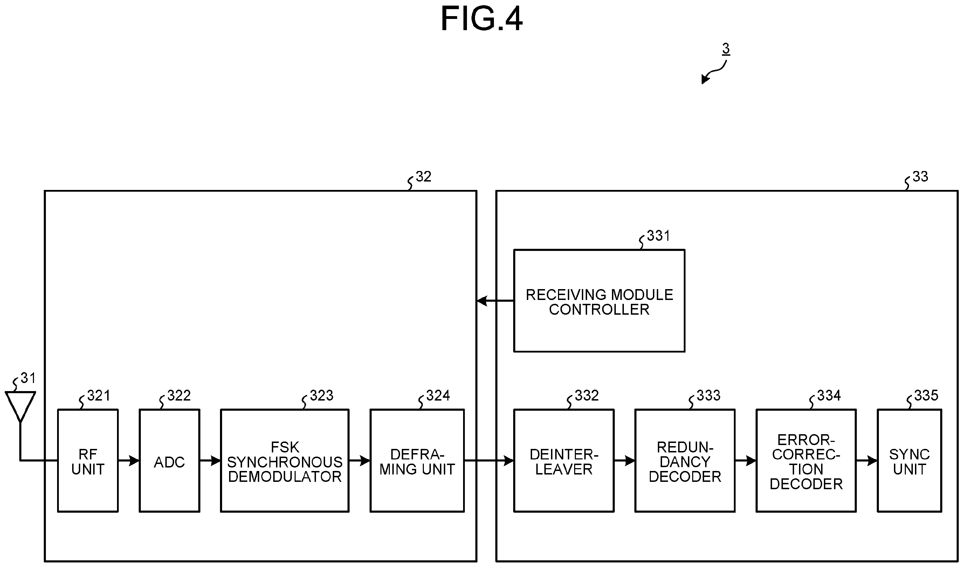

FIG. 4 is a diagram illustrating a functional configuration of the receiving apparatus 3 illustrated in FIG. 1. The receiving module 32 of the receiving apparatus 3 includes an RF unit 321, an analog-to-digital converter (ADC) 322, a FSK synchronous demodulator 323, and a deframing unit 324. The receiving module 32 has both the function of a receiving circuit and the function of a demodulation circuit.

The RF unit 321 performs frequency conversion on a reception signal received by the receiving antenna 31 and outputs the converted reception signal to the ADC 322. The ADC 322 converts the reception signal that is an analog signal output from the RF unit 321 into a digital signal. The ADC 322 outputs the converted reception signal to the FSK synchronous demodulator 323. The FSK synchronous demodulator 323 performs predetermined synchronous processing and demodulation processing on the reception signal output from the ADC 322. Specifically, the FSK synchronous demodulator 323 synchronizes the reception signal and then demodulates the reception signal to generate a binary hard decision sequence. The FSK synchronous demodulator 323 outputs the generated binary hard decision sequence to the deframing unit 324. The deframing unit 324 performs predetermined deframing processing to extract payload data by removing a header portion etc. from the binary hard decision sequence, and outputs the payload data to the external reception control unit 33.

The external reception control unit 33 of the receiving apparatus 3 is a circuit different from the receiving module 32. The external reception control unit 33 includes a receiving module controller 331, a deinterleaver 332, a redundancy decoder 333, an error-correction decoder 334, and a sync unit 335.

The receiving module controller 331 controls the receiving module 32. The deinterleaver 332 performs predetermined deinterleaving processing on the binary hard decision sequence of the reception signal. The deinterleaver 332 outputs the processed reception signal to the redundancy decoder 333. The redundancy decoder 333 performs decoding processing on the redundancy encoding. Specifically, based on the redundancy sequence that is the binary hard decision sequence, the redundancy decoder 333 performs reception reliability weighting on each bit of the encoded sequence, using a plurality of hard decision results of the respective bits. Consequently, the redundancy decoder 333 can obtain a redundancy decoded sequence consisting of the respective soft decision values of the bits of the convolutionally encoded sequence. The redundancy decoder 333 outputs the obtained redundancy decoded sequence to the error-correction decoder 334.

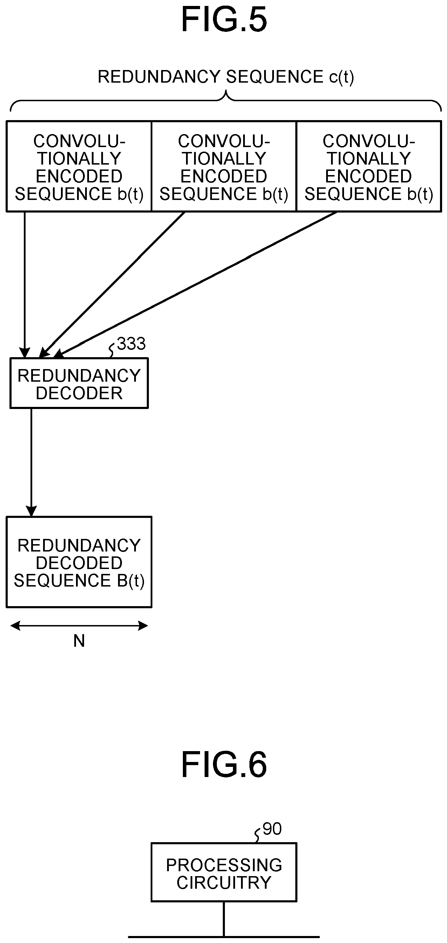

FIG. 5 is a diagram for explaining the processing of the redundancy decoder 333 illustrated in FIG. 4. The redundancy sequence $c(t)$ that is the binary hard decision results of the reception signal is input to the redundancy decoder 333. Here, the redundancy sequence $c(t)$ includes three convolutionally encoded sequences $b(t)$. The redundancy decoder 333 obtains the soft decision result of each bit, that is, the probability that each bit is "0" or "1" on the basis of the bit-by-bit hard decision results of the three convolutionally encoded sequences $b(t)$. The redundancy decoder 333 generates a redundancy decoded sequence $B(t)$ on the basis of the soft decision results. The redundancy decoded sequence B(t) is a multilevel sequence. The redundancy decoded sequence B(t) is expressed by formula (1) below where N is the sequence length of the convolutionally encoded sequence b(t), nosq is the number of repetitions, and d(nosq*N+t) is the corresponding bit of the convolutionally encoded sequence b(t). The redundancy decoder 333 determines the redundancy decoded sequence B(t) by subtracting the number of times the hard decision result of each bit is "0" from the number of times the hard decision result of the bit is "1".

[Formula 1]

$$B(t) = \sum_{nosq=0}^{2} \{2 * d(nosq * N + t) - 1\} \quad \cdots (1)$$

As can be seen from formula (1), since the number of repetitions nosq=3 in the above example, the value of B(t) takes one of -3, -1, +1, and +3. The larger the absolute value, the higher the reliability of the reception signal.

Return to the description of FIG. 4. The error-correction decoder 334 performs error-correction decoding processing on the redundancy decoded sequence B(t) that is a multilevel sequence output from the redundancy decoder 333. The error-correction decoder 334 outputs the processed sequence to the sync unit 335. The sync unit 335 acquires an information bit sequence included in the reception signal.

As described above, in the communication system 1 according to the present embodiment, the transmitting apparatus 2 includes the transmitting module 22 that is a fixed circuit whose internal processing procedure cannot be changed, and the receiving apparatus 3 includes the receiving module 32 that is a fixed circuit whose internal processing procedure cannot be changed. The external transmission control unit 21 having the function of controlling the transmitting module 22 and the function of providing transmission data to the transmitting module 22 includes the redundancy encoder 214 that provides redundancy of an error-correction encoded sequence of transmission data. The external reception control unit 33 having the function of controlling the receiving module 32 and the function of processing a reception signal received by the receiving module 32 includes the redundancy decoder 333 that generates soft decision results from the hard decision results of the redundancy sequence c(t) generated by the receiving module 32, and generates the redundancy decoded sequence B(t) that is a multilevel sequence. Having this configuration can increase the probability that transmission data can be correctly restored while reducing development time and costs by using general-purpose circuits.

Next, hardware configurations of the transmitting apparatus 2 and the receiving apparatus 3 illustrated in FIG. 1 will be described. Each of the external transmission control unit 21, the transmitting module 22, the receiving module 32, and the external reception control unit 33 is implemented by a processing circuitry. These processing circuitries may be implemented by dedicated hardware, or may be a control circuit using a central processing unit (CPU).

When the processing circuitries are implemented by dedicated hardware, they are implemented by a processing circuitry 90 illustrated in FIG. 6. FIG. 6 is a diagram illustrating dedicated hardware for implementing the functions of the transmitting apparatus 2 and the receiving apparatus 3 illustrated in FIG. 1. The processing circuitry 90 is a single circuit, a combined circuit, a programmed processor, a parallel-programmed processor, an application-specific integrated circuit (ASIC), a fieldprogrammable gate array (FPGA), or a combination of them.

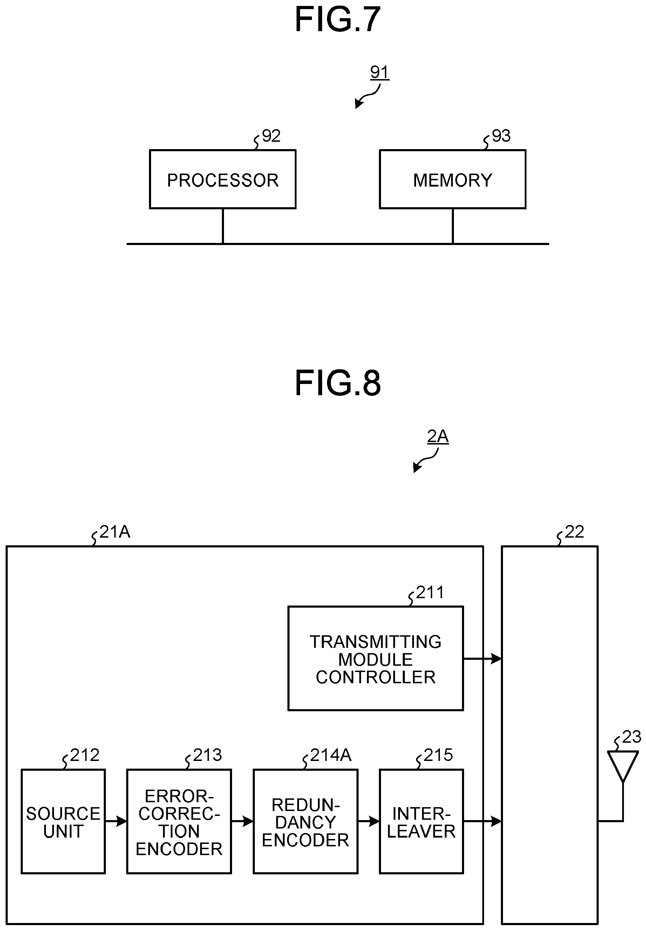

When the processing circuitries are implemented by a control circuit using a CPU, the control circuit is, for example, a control circuit 91 of a configuration illustrated in FIG. 7. FIG. 7 is a diagram illustrating the configuration of the control circuit 91 for implementing the functions of the transmitting apparatus 2 and the receiving apparatus 3 illustrated in FIG. 1. As illustrated in FIG. 7, the control circuit 91 includes a processor 92 and a memory 93. The processor 92 is a CPU and is also called a central processor, a processing unit, an arithmetic unit, a microprocessor, a microcomputer, a digital signal processor (DSP), etc. The memory 93 is, for example, a nonvolatile or volatile semiconductor memory such as a random-access memory (RAM), a read-only memory (ROM), a flash memory, an erasable programmable ROM (EPROM), or an electrically EPROM (EEPROM) (registered trademark), or a magnetic disk, a flexible disk, an optical disk, a compact disk, a mini disk, a digital versatile disk (DVD), or the like.

When implemented by the control circuit 91, the processing circuitries are implemented by the processor 92 reading and executing programs corresponding to the processing of the components stored in the memory 93. The memory 93 is also used as a temporary memory in individual processing executed by the processor 92.

In the above embodiment, the transmitting apparatus 2 does not have a receiving function, and the receiving apparatus 3 does not have a transmitting function. However, the present embodiment is not limited to this example. The communication system 1 may include a plurality of communication apparatuses having both the function of the transmitting apparatus 2 and the function of the receiving apparatus 3.

Further, the technology described above may be implemented not only as the communication system 1, the transmitting apparatus 2, and the receiving apparatus 3 but also as control circuits that implement the respective functions of the external transmission control unit 21 and the external reception control unit 33. Furthermore, the technology of the present invention may be implemented as a computer program describing a processing procedure of a control circuit. The computer program may be provided via a communication path or may be provided in a state of being recorded on a storage medium. Moreover, the technology of the present invention may be implemented as a communication method including the processing procedure of the communication system 1.

Second Embodiment.

FIG. 8 is a diagram illustrating a functional configuration of a transmitting apparatus 2A according to a second embodiment of the present invention. The following mainly describes part of the functional configuration of the transmitting apparatus 2A different from that of the transmitting apparatus 2 according to the first embodiment. The part similar to that of the transmitting apparatus 2 will not be described.

The transmitting apparatus 2A includes an external transmission control unit 21A, the transmitting module 22, and the transmitting antenna 23. The external transmission control unit 21A includes the transmitting module controller 211, the source unit 212, the error-correction encoder 213, a redundancy encoder 214A, and the interleaver 215. The transmitting apparatus 2A includes the redundancy encoder 214A instead of the redundancy encoder 214 of the transmitting apparatus 2.

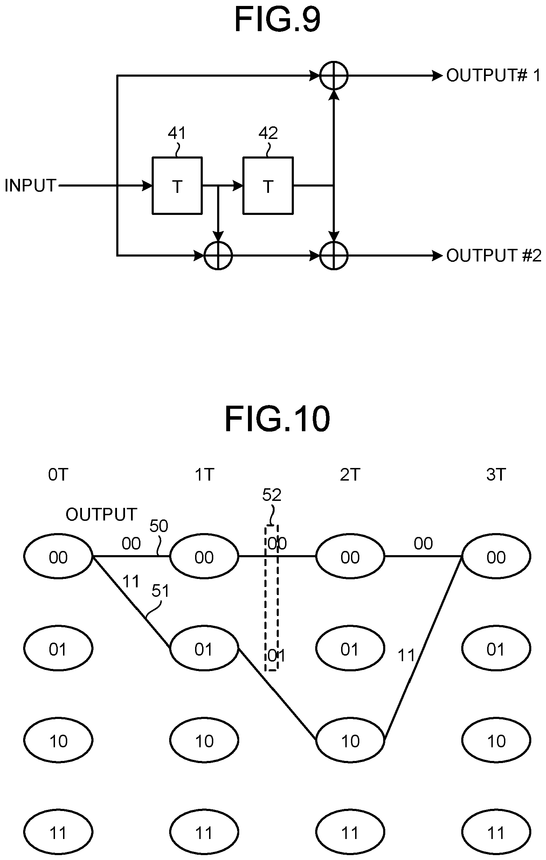

FIG. 9 is a diagram for explaining the function of the error-correction encoder 213 illustrated in FIG. 8. Here, an example of the constraint length "3" and the code rate "1/2" will be used for description. The error-correction encoder 213 includes two shift registers 41 and 42. For an Input, four state transitions are made. For one Input, Outputs #1 and #2 of two systems are obtained.

FIG. 10 is a diagram for explaining the function of the redundancy encoder 214A illustrated in FIG. 8. FIG. 10 expresses FIG. 9 in a trellis diagram. Comparing minimum paths 50 and 51 in the trellis diagram of FIG. 10, bits constituting the minimum paths 50 and 51 fixedly include common bits between the two paths, that is, common bits 52 having no difference. Such bits are referred to as common bits. It is apparent that removing common bits on the transmission side does not affect decoding. Thus, the redundancy encoder 214A removes common bits from the convolutionally encoded sequence.

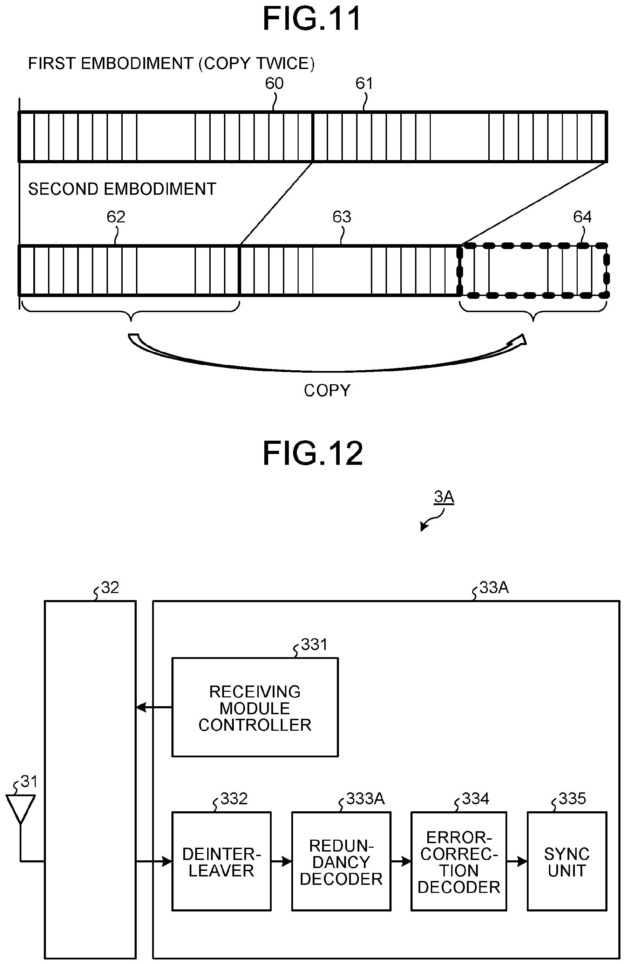

FIG. 11 is a diagram for explaining the effect of the redundancy encoder 214A illustrated in FIG. 8. An upper diagram in FIG. 11 illustrates a redundancy sequence generated by the redundancy encoder 214 described in the first embodiment. In the first embodiment, when the number of repetitions is two, the redundancy sequence includes two convolutionally encoded sequences 60 and 61. On the other hand, the redundancy encoder 214A according to the second embodiment removes common bits from the convolutionally encoded sequence. Thus, the sequence length of convolutionally encoded sequences 62 and 63 after the removal is shorter than the sequence length of the convolutionally encoded sequences 60 and 61 in the first embodiment. Consequently, when the redundant encoded sequence has the same sequence length, excess bits 64 are left. The redundancy encoder 214A assigns bits that are a copy of the convolutionally encoded sequence 62 after the removal to the excess bits 64. For example, the redundancy encoder 214A copies as many bit values as the number of the excess bits 64 from the head of the convolutionally encoded sequence 62 for assignment to the excess bits 64.

FIG. 12 is a diagram illustrating a functional configuration of a receiving apparatus 3A according to the second embodiment of the present invention. The following mainly describes part of the functional configuration of the receiving apparatus 3A different from that of the receiving apparatus 3 according to the first embodiment. The part similar to that of the receiving apparatus 3 will not be described.

The receiving apparatus 3 includes the receiving antenna 31, the receiving module 32, and an external reception control unit 33A. The external reception control unit 33A includes the receiving module controller 331, the deinterleaver 332, a redundancy decoder 333A, the error-correction decoder 334, and the sync unit 335. The external reception control unit 33A includes the redundancy decoder 333A instead of the redundancy decoder 333 of the external reception control unit 33 according to the first embodiment.

Using the binary hard decision sequence output from the receiving module 32, the redundancy decoder 333A performs redundancy decoding by extracting redundancy bits corresponding to the respective bits of the convolutionally encoded sequence, and converting the sequence into a multilevel sequence. In the present embodiment, the number of times of copying varies depending on the bits. This results in a multilevel sequence whose bits have different maximum values. The redundancy decoder 333A inserts zeros in the removed bits, and obtains, for the other bits, a multilevel sequence representing reliability using formula (1) described above, on the basis of the numbers of the copies.

As described above, according to the present embodiment, the redundancy encoder 214A allocates the excess bits 64 resulting from the removal of the common bits from the convolutionally encoded sequences for the transmission of the convolutionally encoded sequence 62 after the removal. This can increase the redundancy of the redundant encoded sequence. Consequently, the reception success rate for one transmission can be improved compared to that of the first embodiment.

Third Embodiment.

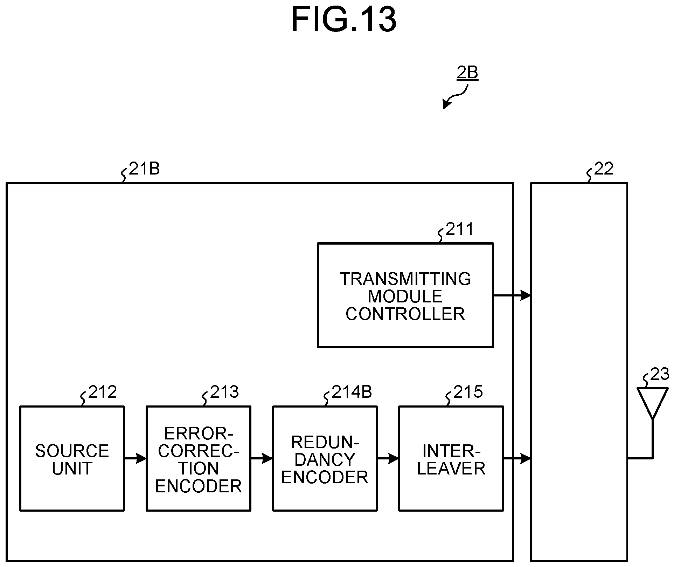

FIG. 13 is a diagram illustrating a functional configuration of a transmitting apparatus 2B according to a third embodiment of the present invention. The following mainly describes part of the functional configuration of the transmitting apparatus 2B different from that of the transmitting apparatus 2 according to the first embodiment. The part similar to that of the transmitting apparatus 2 will not be described.

The transmitting apparatus 2B includes an external transmission control unit 21B, the transmitting module 22, and the transmitting antenna 23. The external transmission control unit 21B includes the transmitting module controller 211, the source unit 212, the error-correction encoder 213, a redundancy encoder 214B, and the interleaver 215.

It is desirable that the redundancy code rate can be flexibly changed for application to various systems. For this, by removing common bits after convolutional encoding and then performing redundancy encoding, the redundancy code rate can be flexibly changed. However, if a removal pattern is fixed, information on the removed bits is missing even when redundancy decoding is performed. As a result, reception performance may be degraded.

The redundancy encoder 214B according to the present embodiment stores in advance a plurality of different removal patterns, and generates a redundant encoded sequence using a different removal pattern each time a convolutionally encoded sequence is input. For example, at the code rate 2/3, the removal patterns are [1, 1, 0], [1, 0, 1], and [0, 1, 1]. The removal patterns are represented by three-bit periods. For example, [1, 1, 0] indicates the removal of the third bit.

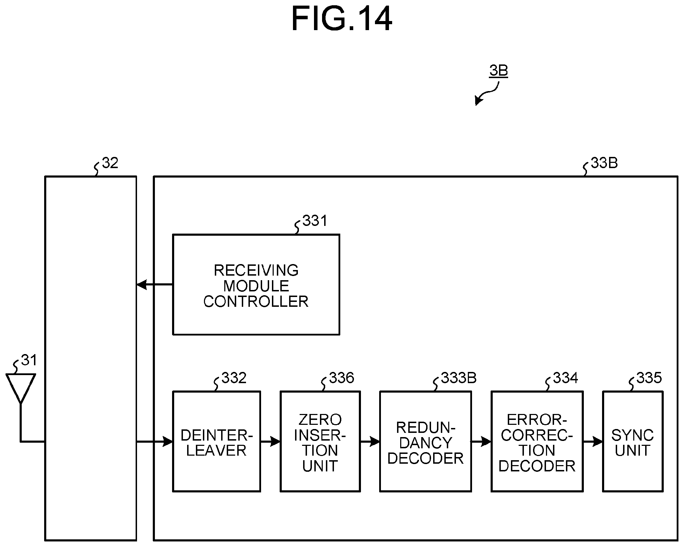

FIG. 14 is a diagram illustrating a functional configuration of a receiving apparatus 3B according to the third embodiment of the present invention. The following mainly describes part of the functions of the receiving apparatus 3B different from that of the receiving apparatus 3 according to the first embodiment. The part similar to that of the receiving apparatus 3 will not be described.

The receiving apparatus 3B includes the receiving antenna 31, the receiving module 32, and an external reception control unit 33B. The external reception control unit 33B includes the receiving module controller 331, the deinterleaver 332, a zero insertion unit 336, a redundancy decoder 333B, the error-correction decoder 334, and the sync unit 335.

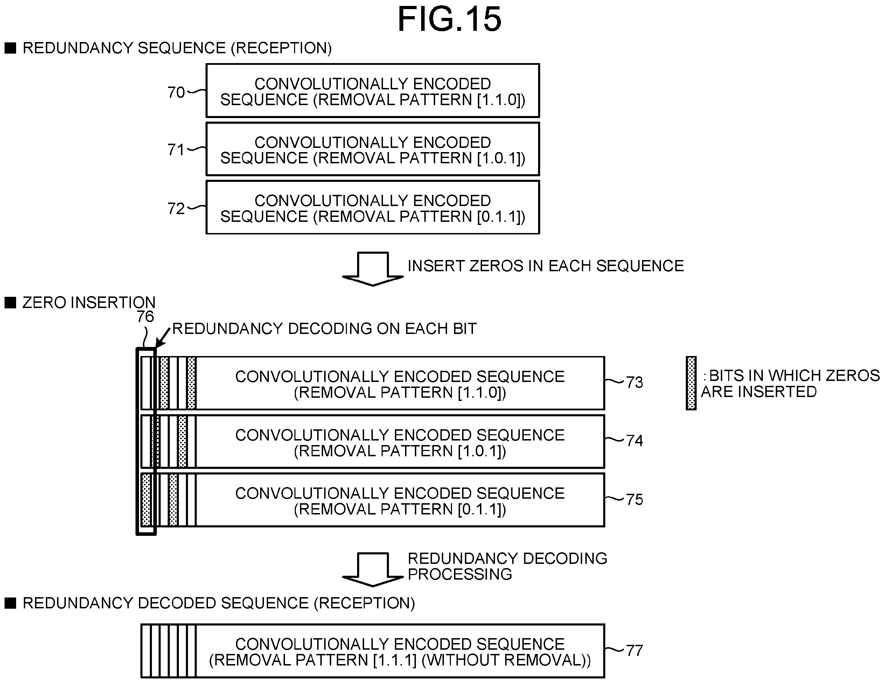

FIG. 15 is a diagram for explaining the functions of the zero insertion unit 336 and the redundancy decoder 333B illustrated in FIG. 14. A redundancy sequence output from the deinterleaver 332 includes convolutionally encoded sequences 70, 71, and 72 subjected to removal in different removal patterns. The zero insertion unit 336 stores the removal patterns used by the transmitting apparatus 2B, and inserts zeros in removed bits using the respective removal patterns for the convolutionally encoded sequences 70, 71, and 72. The zero insertion unit 336 outputs convolutionally encoded sequences 73, 74, and 75 after the zero insertion to the redundancy decoder 333B.

The redundancy decoder 333B performs redundancy decoding processing on each bit 76 of the convolutionally encoded sequences 73, 74, and 75 after the zero insertion to obtain a redundancy decoded sequence 77 that is a multilevel sequence. The redundancy decoder 333B outputs the obtained redundancy decoded sequence 77 to the error-correction decoder 334.

As described above, according to the third embodiment of the present invention, bits are removed using a different removal pattern for each of a plurality of convolutionally encoded sequences included in a redundancy sequence. This can avoid a state in which only bits at specific positions have no reliability information, thus allowing a good reception rate to be maintained even when removal processing is performed.

For removal patterns, minimum paths described in the second embodiment may be taken into account. When removal patterns with minimum paths taken into account are used, a plurality of removal patterns are used in which common bits that do not affect minimum path decoding performance are preferentially removed, and for the other bits, specific bits are prevented from being missing on the receiving side. In redundancy encoding, a plurality of removal patterns resulting in different code rates may be used in combination. The technology of the present invention is not limited to the above examples.

Fourth Embodiment.

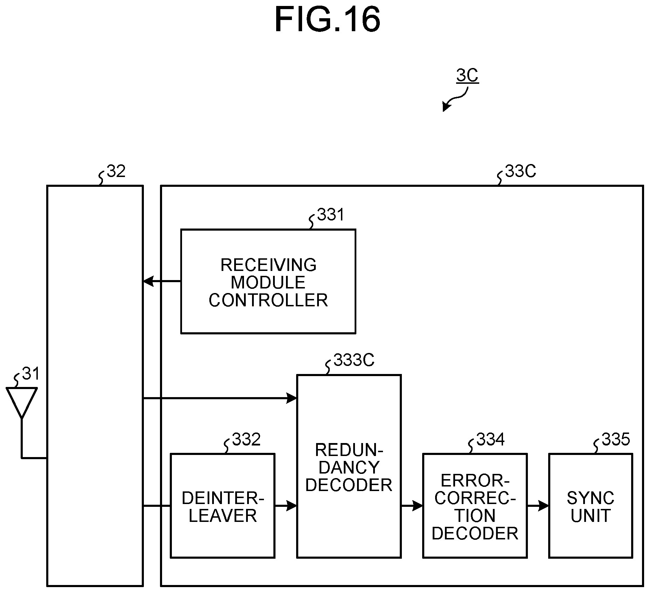

FIG. 16 is a diagram illustrating a functional configuration of a receiving apparatus 3C according to a fourth embodiment of the present invention. The receiving apparatus 3C includes the receiving antenna 31, the receiving module 32, and an external reception control unit 33C. The following mainly describes part of the functions of the receiving apparatus 3C different from that of the receiving apparatus 3 according to the first embodiment. The part similar to that of the receiving apparatus 3 will not be described.

The external reception control unit 33C includes the receiving module controller 331, the deinterleaver 332, a redundancy decoder 333C, the error-correction decoder 334, and the sync unit 335.

In the first to third embodiments, the redundancy decoders 333, 333A, and 333B calculate the redundancy decoded sequence B(t) that is a multilevel sequence, using the binary hard decision sequence obtained from the receiving module 32 and using formula (1). However, if a radio propagation path has a weak electric field locally in a section in which a redundant encoded sequence is transmitted, the reliability of a binary hard decision sequence d(t) in the section deteriorates. Therefore, when a multilevel sequence is generated, it may be better to perform weighting according to reliability before combining, or not to use a binary hard decision sequence of low reliability. Further, to simplify calculation, weighting is desirably performed using limited discrete values.

Thus, when part of a section in a redundant encoded sequence has a weak electric field, the redundancy decoder 333C obtains a weighting discrete value w expressed by formula (2) below, on the basis of a received signal strength indicator (RSSI) value obtained from the receiving module 32. Here, th1 and th2 are predetermined threshold values.

[Formula 2]

$$w(NoSq, t) = \begin{cases} 0 & if\ RSSI(NoSq, t) < th1 \\ 0.5 & elseif\ th1 \leqq RSSI(NoSq, t) < th2 \\ 1 & otherwise \end{cases} \cdots (2)$$

The redundancy decoder 333C obtains the redundancy decoded sequence B(t) using formula (3) below using the weighting discrete value w.

[Formula 3]

$$B(t) = \sum_{Sq=1}^{NoSq} w(Sq, t)d(Sq, t) \quad \cdots (3)$$

The redundancy decoder 333C acquires a binary hard decision sequence from the deinterleaver 332 and acquires an RSSI value from the receiving module 32. The redundancy decoder 333C performs redundancy decoding processing using the weighting discrete value w based on the magnitude of the RSSI value.

As described above, according to the fourth embodiment of the present invention, the redundancy decoder 333C performs weighting on the basis of the magnitude of an RSSI value to perform redundancy decoding. Consequently, even if part of the section of a redundant encoded sequence has a weak electric field and the reliability thereof decreases, the influence of a redundant encoded sequence in a section of high reliability on a redundancy decoded sequence becomes large, and the influence of a redundant encoded sequence in a section of low reliability on the redundancy decoded sequence becomes small. Thus, the reception rate can be improved. In addition, since discrete values are used in weighting, calculation can be simplified.

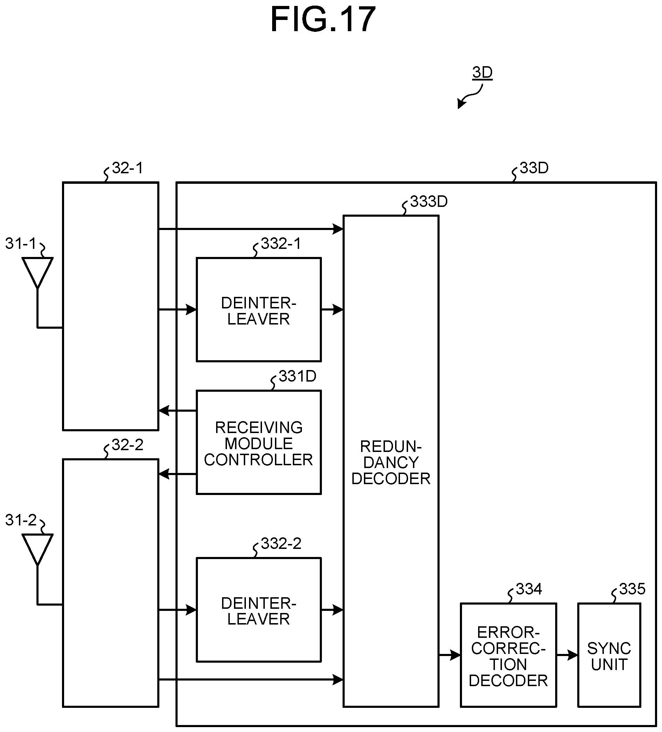

FIG. 17 is a diagram illustrating a functional configuration of a receiving apparatus 3D according to a first modification of the fourth embodiment of the present invention. The receiving apparatus 3D includes a plurality of receiving antennas 31-1 and 31-2, a plurality of receiving modules 32-1 and 32-2 corresponding to the plurality of receiving antennas 31-1 and 31-2, respectively, and an external reception control unit 33D.

Each of the receiving modules 32-1 and 32-2 has a configuration similar to the receiving module 32.

The external reception control unit 33D includes a receiving module controller 331D, deinterleavers 332-1 and 332-2, a redundancy decoder 333D, the error-correction decoder 334, and the sync unit 335. The function of the receiving module controller 331D is similar to that of the receiving module controller 331 except for controlling the plurality of receiving modules 32-1 and 32-2.

RSSI values output from the receiving modules 32-1 and 32-2 are input to the redundancy decoder 333D. A binary hard decision sequence output from the receiving module 32-1 is input to the redundancy decoder 333D via the deinterleaver 332-1. A binary hard decision sequence output from the receiving module 32-2 is input to the redundancy decoder 333D via the deinterleaver 332-2.

In the receiving apparatus 3D including the plurality of receiving antennas 31-1 and 31-2, the redundancy decoder 333D can combine values that have been weighted using weighting discrete values between the receiving antennas 31-1 and 31-2, to obtain the redundancy decoded sequence B(t) that is a multilevel sequence. The redundancy decoder 333D obtains the redundancy decoded sequence B(t) using formula (4) below. In formula (4), nr is a receiving antenna index.

[Formula 4]

$$B(t) = \sum_{nr=1}^{2} \sum_{Sq=1}^{NoSq} w(Sq, nr, t)d(Sq, nr, t) \quad \cdots (4)$$

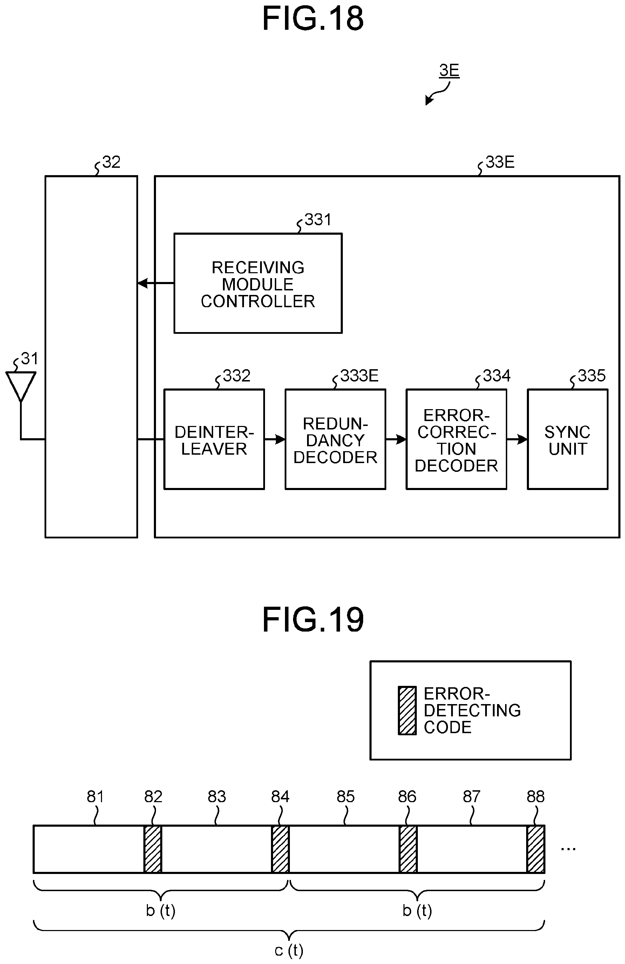

FIG. 18 is a diagram illustrating a functional configuration of a receiving apparatus 3E according to a second modification of the fourth embodiment of the present invention. The receiving apparatus 3E includes the receiving antenna 31, the receiving module 32, and an external reception control unit 33E.

The external reception control unit 33E includes the receiving module controller 331, the deinterleaver 332, a redundancy decoder 333E, the error-correction decoder 334, and the sync unit 335.

The redundancy decoder 333E performs weighting on each bit of a redundant encoded sequence using an error-detecting code instead of an RSSI value. In this case, error-detecting codes are inserted in a reception signal received by the receiving apparatus 3E at intervals of a predetermined number of bits.

FIG. 19 is a diagram for explaining the function of the redundancy decoder 333E illustrated in FIG. 18. The redundancy sequence c(t) input to the redundancy decoder 333E includes the plurality of convolutionally encoded sequences b(t). Error-detecting codes 82, 84, 86, and 88 are inserted in the convolutionally encoded sequences b(t) at intervals of a predetermined number of bits between binary hard decision sequences 81, 83, 85, and 87.

The redundancy decoder 333E performs redundancy decoding processing using the binary hard decision sequences 81, 83, 85, and 87 and the error-detecting codes 82, 84, 86, and 88. For example, the redundancy decoder 333E may perform the redundancy decoding processing using formula (5) below.

[Formula 5]

$$(NoSq, t) = \begin{cases} 1 & if \quad Error\ detection\ not\ detected \\ 0.2 & otherwise \end{cases} \quad \cdots (5)$$

According to formula (5) above, the weight is set to 0.2 for a section in which an error is detected, and the weight is set to 1.0 for a section in which an error is not ) detected. If a large number of bits can be used as error-detecting codes, the weight may be set to 0 when an error is detected. If a small number of bits can be used as error-detecting codes, there is a possibility of erroneous detection even when an error is detected, and thus a fractional weight may be set.

The redundancy decoder 333E can obtain a multilevel sequence by performing the redundancy decoding processing on the binary hard decision sequences 81 and 85 and the binary hard decision sequences 83 and 87. Using error-detecting codes in this manner allows error-detecting codes to be inserted with an arbitrary period, and allows the receiving side to perform more proper redundancy decoding processing on the basis of error detection results. In addition, compared to the case of using an RSSI value, the number of connection signal lines of the receiving module 32 can be reduced, so that the circuit scale can be reduced. However, as in the case of using an RSSI value, an error detection result may be output from a port of the receiving module 32 different from that for a binary hard decision sequence. The above-described mode using error-detecting codes is also applicable to a configuration using a plurality of receiving antennas. On the basis of error detection results from the receiving modules 32 connected to the corresponding receiving antennas, weighted redundancy decoding processing including antenna diversity may be performed.

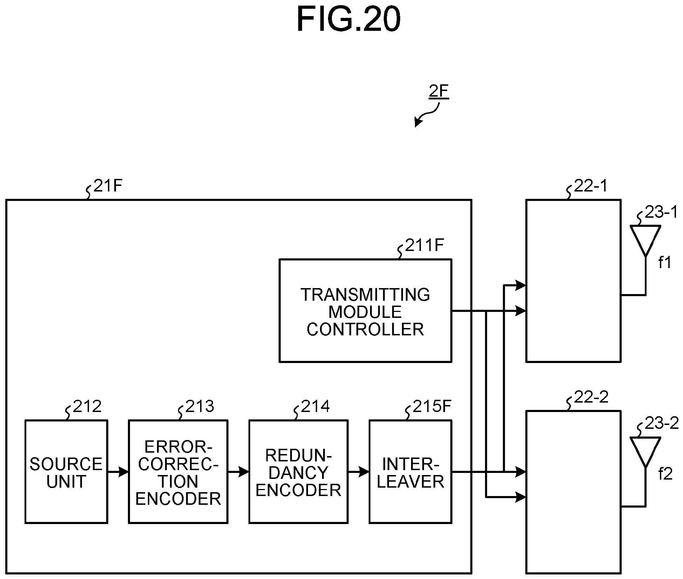

FIG. 20 is a diagram illustrating a functional configuration of a transmitting apparatus 2F according to a third modification of the fourth embodiment of the present invention. The transmitting apparatus 2F includes an external transmission control unit 21F, a plurality of transmitting modules 22-1 and 22-2, and a plurality of transmitting antennas 23-1 and 23-2. The plurality of transmitting modules 22-1 and 22-2 are provided for the plurality of transmitting antennas 23-1 and 23-2, respectively.

The external transmission control unit 21F includes a transmitting module controller 211F, the source unit 212, the error-correction encoder 213, the redundancy encoder 214, and an interleaver 215F. The transmitting module controller 211F has a function similar to the transmitting module controller 211 except for controlling the plurality of transmitting modules 22-1 and 22-2. The transmitting module controller 211F allocates different carrier frequencies f1 and f2 to the plurality of transmitting modules 22-1 and 22-2, respectively. The interleaver 215F outputs a redundancy sequence to each of the plurality of transmitting modules 22-1 and 22-2. Thus, the transmitting apparatus 2F transmits the same modulated signal from the different transmitting modules 22-1 and 22-2.

If the configuration on the receiving side includes one receiving antenna 31 and one receiving module 32, in order to receive a signal transmitted at a plurality of frequencies, reception frequencies are switched alternately to perform reception. Having this configuration allows a multilevel sequence of high reliability to be obtained in both transmission and reception by selection diversity using a plurality of frequencies while using the transmitting modules 22 and the receiving module 32 that are fixed circuits whose internal processing procedures cannot be changed.

Further, it is possible to apply the redundancy decoding processing including weighting using an RSSI value or an error-detecting code even when the plurality of transmitting antennas 23-1 and 23-2 and the plurality of transmitting modules 22-1 and 22-2 are used.

The functions of the transmitting apparatuses 2A, 2B, and 2F and the receiving apparatuses 3A, 3B, 3C, 3D, and 3E described in the second to fourth embodiments can be implemented by the processing circuitry 90 illustrated in FIG. 6 or the control circuit 91 illustrated in FIG. 7 as in the first embodiment.

The configurations described in the above embodiments show examples of the subject matter of the present invention, and can be combined with another known art, and can be partly omitted or changed without departing from the scope of the present invention.

Reference Signs List

1 communication system; 2, 2A, 2B, 2F transmitting apparatus; 3, 3A, 3B, 3C, 3D, 3E receiving apparatus; 21, 21A, 21B, 21F external transmission control unit; 22, 22-1, 22-2 transmitting module; 23, 23-1, 23-2 transmitting antenna; 31, 31-1, 31-2 receiving antenna; 32, 32-1, 32-2 receiving module; 33, 33A, 33B, 33C, 33D, 33E external reception control unit; 41, 42 shift register; 50, 51 minimum path; 52 common bit; 90 processing circuitry; 91 control circuit; 92 processor; 93 memory; 211, 211F transmitting module controller; 212 source unit; 213 error-correction encoder; 214, 214A, 214B redundancy encoder; 215, 215F interleaver; 221 framing unit; 222 FSK modulator; 223 DAC; 224, 321 RF unit; 322 ADC; 323 FSK synchronous demodulator; 324 deframing unit; 331, 331D receiving module controller; 332, 332-1, 332-2 deinterleaver; 333, 333A, 333B, 333C, 333D, 333E redundancy decoder; 334 error-correction decoder; 335 sync unit; 336 zero insertion unit.

**Claims**

1. A transmitting apparatus comprising:

   a transmitting module that is a fixed circuit whose internal processing procedure is not able to be changed, the transmitting module performing modulation processing on transmission data; and
   an external transmission control unit including a transmitting module controller to control the transmitting module according to redundancy encoding processing for conversion into a multilevel sequence on a receiving side, and a redundancy encoder to redundantly encode transmission data using an error-correction encoded sequence, the external transmission control unit providing a redundant encoded sequence obtained by redundantly encoding the transmission data to the transmitting module.

2. The transmitting apparatus according to claim 1, wherein

   the error-correction encoded sequence is a convolutionally encoded sequence, and
   the redundancy encoder removes, of bits constituting each of a plurality of minimum paths, bits common between the plurality of minimum paths from the convolutionally encoded sequence.

3. The transmitting apparatus according to claim 2, wherein the redundancy encoder allocates resources scheduled to be allocated to the bits removed from the convolutionally encoded sequence for redundantly encoding the convolutionally encoded sequence after the removal.

4. The transmitting apparatus according to any one of claims 1 to 3, wherein the redundancy encoder has a plurality of different removal patterns, and removes bits of the error-correction encoded sequence using a different removal pattern each time redundancy encoding is performed on one error-correction encoded sequence.

5. The transmitting apparatus according to any one of claims 1 to 4, wherein

   the transmitting apparatus comprises a plurality of the transmitting modules, and
   the external transmission control unit instructs each of the plurality of transmitting modules on a different frequency, and provides the redundant encoded sequence to each of the plurality of transmitting modules.

6. A receiving apparatus comprising:

   a receiving module that is a fixed circuit whose internal processing procedure is not able to be changed, the receiving module performing demodulation processing on a reception signal to generate a binary hard decision sequence; and
   an external reception control unit including a receiving module controller to control the receiving module, and a redundancy decoder to redundantly decode the binary hard decision sequence output from the receiving module for conversion into a multilevel sequence.

7. The receiving apparatus according to claim 6, wherein the redundancy decoder redundantly decodes the binary hard decision sequence by combining values weighted based on reliability.

8. The receiving apparatus according to claim 7, wherein the redundancy decoder weights the binary hard decision sequence using discrete values.

9. The receiving apparatus according to claim 7 or 8, wherein the external reception control unit acquires error-detecting codes or error detection results indicating the reliability from the receiving module.

10. The receiving apparatus according to any one of claims 6 to 9, wherein

   the receiving apparatus comprises a plurality of the receiving modules, and
   the redundancy decoder performs reception diversity combining and redundancy decoding processing, using the binary hard decision sequence output from each of the plurality of receiving modules.

11. The receiving apparatus according to any one of claims 6 to 10, wherein the receiving module controller causes the plurality of receiving modules to perform reception processing while switching between a plurality of frequencies.

12. A communication system comprising:

   the transmitting apparatus according to any one of claims 1 to 5; and
   the receiving apparatus according to any one of claims 6 to 11.

13. The communication system according to claim 12, wherein

   the transmitting apparatus inserts error-detecting codes at intervals of a predetermined number of bits of the error-correction encoded sequence, and
   the receiving apparatus weights the binary hard decision sequence of the error-correction encoded sequence using the error-detecting codes to perform redundancy decoding processing.

14. A control circuit to cause a communication apparatus to perform:

   a step of controlling a transmitting module that is a fixed circuit whose internal processing procedure is not able to be changed, the transmitting module performing modulation processing on transmission data;
   a step of redundantly encoding transmission data using an error-correction encoded sequence; and
   a step of providing a redundant encoded sequence obtained by redundantly encoding the transmission data to the transmitting module.

15. A control circuit to cause a communication apparatus to perform:

   a step of controlling a receiving module that is a fixed circuit whose internal processing procedure is not able to be changed, the receiving module performing demodulation processing on a reception signal to generate a binary hard decision sequence; and
   a step of redundantly decoding the binary hard decision sequence output from the receiving module for conversion into a multilevel sequence.

16. A communication method to be performed by a transmitting apparatus including a transmitting module and a receiving apparatus including a receiving module, the transmitting module being a fixed circuit whose internal processing procedure is not able to be changed and performing modulation processing on transmission data, and the receiving module being a fixed circuit whose internal processing procedure is not able to be changed and performing demodulation processing on a reception signal to generate a binary hard decision sequence, the communication method comprising:

   a step of redundantly encoding transmission data using an error-correction encoded sequence, by a transmission control unit to control the transmitting module;
   a step of providing a redundant encoded sequence obtained by redundantly encoding the transmission data to the transmitting module, by the transmission control unit; and
   a step of redundantly decoding a binary hard decision sequence output from the receiving module for conversion into a multilevel sequence, by a reception control unit to control the receiving module.

17. A storage medium storing a computer program to control a communication apparatus including a transmitting module, the transmitting module being a fixed circuit whose internal processing procedure is not able to be changed and performing modulation processing on transmission data, the computer program causing the communication apparatus to perform:

a step of redundantly encoding transmission data using an error-correction encoded sequence; and
a step of providing a redundant encoded sequence obtained by redundantly encoding the transmission data to the transmitting module.

18. A storage medium storing a computer program to control a communication apparatus including a receiving module, the receiving module being a fixed circuit whose internal processing procedure is not able to be changed and performing demodulation processing on a reception signal to generate a binary hard decision sequence, the computer program causing the communication apparatus to perform:
a step of redundantly decoding the binary hard decision sequence output from the receiving module for conversion into a multilevel sequence.

# FIG.1

EXTERNAL TRANS-MISSION CONTROL UNIT 21

TRANSMITTING MODULE 22

23 31

RECEIVING MODULE 32

EXTERNAL RECEPTION CONTROL UNIT 33

# FIG.2

EP 4 050 827 A1

# FIG.3

REDUNDANCY SEQUENCE c(t)

| CONVOLU-TIONALLY ENCODED SEQUENCE b(t) | REDUN-DANCY → | CONVOLU-TIONALLY ENCODED SEQUENCE b(t) | CONVOLU-TIONALLY ENCODED SEQUENCE b(t) | CONVOLUT-IONALLY ENCODED SEQUENCE b(t) |

N

3N

# FIG.4

3

33

**RECEIVING MODULE CONTROLLER** 331

**DEINTER-LEAVER** 332

**REDUN-DANCY DECODER** 333

**ERROR-CORREC-TION DECODER** 334

**SYNC UNIT** 335

32

**RF UNIT** 321

**ADC** 322

**FSK SYNCHRONOUS DEMODULATOR** 323

**DEFRA-MING UNIT** 324

31

# FIG.5

REDUNDANCY SEQUENCE c(t)

| CONVOLU-TIONALLY ENCODED SEQUENCE b(t) | CONVOLU-TIONALLY ENCODED SEQUENCE b(t) | CONVOLU-TIONALLY ENCODED SEQUENCE b(t) |
|---|---|---|

~333

REDUNDANCY DECODER

REDUNDANCY DECODED SEQUENCE B(t)

N

# FIG.6

~90

PROCESSING CIRCUITRY

# FIG.7

<u>91</u>

| 92 | 93 |
|---|---|
| PROCESSOR | MEMORY |

# FIG.8

<u>2A</u>

211
TRANSMITTING
MODULE
CONTROLLER

21A

22

23

212
SOURCE
UNIT

213
ERROR-
CORREC-
TION
ENCODER

214A
REDUN-
DANCY
ENCODER

215
INTER-
LEAVER

# FIG.9

# FIG.10

# FIG.11

FIRST EMBODIMENT (COPY TWICE)

SECOND EMBODIMENT

COPY

# FIG.12

# FIG.13

# FIG.14

3B

32

33B

331

RECEIVING
MODULE
CONTROLLER

31

332

DEINTER-
LEAVER

336

ZERO
INSER-
TION
UNIT

333B

REDUN-
DANCY
DECODER

334

ERROR-
CORREC-
TION
DECODER

335

SYNC
UNIT

# FIG.15

■ REDUNDANCY SEQUENCE (RECEPTION)

70 — CONVOLUTIONALLY ENCODED
SEQUENCE (REMOVAL PATTERN [1.1.0])

71 — CONVOLUTIONALLY ENCODED
SEQUENCE (REMOVAL PATTERN [1.0.1])

72 — CONVOLUTIONALLY ENCODED
SEQUENCE (REMOVAL PATTERN [0.1.1])

⇩ INSERT ZEROS IN EACH SEQUENCE

■ ZERO INSERTION
76

REDUNDANCY DECODING ON EACH BIT

CONVOLUTIONALLY ENCODED SEQUENCE
(REMOVAL PATTERN [1.1.0]) — 73

CONVOLUTIONALLY ENCODED SEQUENCE
(REMOVAL PATTERN [1.0.1]) — 74

CONVOLUTIONALLY ENCODED SEQUENCE
(REMOVAL PATTERN [0.1.1]) — 75

▓ : BITS IN WHICH ZEROS
ARE INSERTED

⇩ REDUNDANCY DECODING
PROCESSING

■ REDUNDANCY DECODED SEQUENCE (RECEPTION)

CONVOLUTIONALLY ENCODED SEQUENCE
(REMOVAL PATTERN [1.1.1] (WITHOUT REMOVAL)) — 77

EP 4 050 827 A1

# FIG.16

# FIG.17

# FIG.18

3E

32        33E

331

RECEIVING
MODULE
CONTROLLER

31

332    333E    334    335

DEINTER-
LEAVER

REDUN-
DANCY
DECODER

ERROR-
CORREC-
TION
DECODER

SYNC
UNIT

# FIG.19

ERROR-
DETECTING
CODE

81    82    83    84    85    86    87    88

b (t)           b (t)

c (t)

# FIG.20

<table>
<tr><td colspan="2" align="center">**INTERNATIONAL SEARCH REPORT**</td><td>International application No.<br>PCT/JP2019/036188</td></tr>
</table>

**A. CLASSIFICATION OF SUBJECT MATTER**
Int. Cl. H04L1/08(2006.01)i, H03M13/23(2006.01)i, H03M13/43(2006.01)i

According to International Patent Classification (IPC) or to both national classification and IPC

**B. FIELDS SEARCHED**

Minimum documentation searched (classification system followed by classification symbols)
Int. Cl. H04L1/08, H03M13/23, H03M13/43

Documentation searched other than minimum documentation to the extent that such documents are included in the fields searched
Published examined utility model applications of Japan    1922-1996
Published unexamined utility model applications of Japan  1971-2019
Registered utility model specifications of Japan          1996-2019
Published registered utility model applications of Japan  1994-2019

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 62-136939 A (NIPPON TELEGRAPH AND TELEPHONE CORP.) 19 June 1987, page 203, upper right column, line 5 to lower right column, line 11 & US 4763331 A, columns 4-8 & GB 2185367 A & SE 8605236 A & CA 1296065 A & SE 463845 B | 1-6, 10-12, 14-18 |
| A | | 7-9, 13 |
| Y | JP 11-346383 A (DIRECTOR GENERAL OF COMMUNICATIONS RESEARCH LABORATORY) 14 December 1999, paragraphs [0007]-[0013] & US 2002/0111187 A1, paragraphs [0012]-[0023] & EP 941002 A2 & CA 2265114 A & KR 10-1999-0077650 A | 1-6, 10-12, 14-18 |
| Y | JP 2000-004215 A (MATSUSHITA ELECTRIC INDUSTRIAL CO., LTD.) 07 January 2000, paragraphs [0012], [0013] & US 6693889 B1, columns 4-5 & EP 966124 A2 | 2-5, 10-11 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>28.10.2019 | Date of mailing of the international search report<br>05.11.2019 |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

**INTERNATIONAL SEARCH REPORT**

| International application No. |
| --- |
| PCT/JP2019/036188 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2002-164793 A (MITSUBISHI ELECTRIC CORP.) 07 June 2002, paragraphs [0026]-[0028] (Family: none) | 2-5, 10-11 |
| A | JP 2014-165830 A (MITSUBISHI ELECTRIC CORP.) 08 September 2014 (Family: none) | 1-18 |
| A | JP 8-186875 A (MATSUSHITA ELECTRIC INDUSTRIAL CO., LTD.) 16 July 1996 (Family: none) | 1-18 |
| A | WO 2007/040018 A1 (MITSUBISHI ELECTRIC CORP.) 12 April 2007 & JP 4598079 B2 & US 2009/0041165 A1 & EP 1914919 A1 & CN 101278509 A | 1-18 |

Form PCT/ISA/210 (continuation of second sheet) (January 2015)

<table>
<tr><td>**INTERNATIONAL SEARCH REPORT**</td><td>International application No.<br>PCT/JP2019/036188</td></tr>
</table>

For the following reasons, no specific claim is excluded from the scope of the search, but the search was conducted only on the portion for which a meaningful search could be conducted.

Claim 1 sets forth "a transmission module controller that controls the transmission module in accordance with redundant encoding processing for converting to a multilevel sequence on the receiving side."

As pertains to this matter, the description (for example, paragraph [0014]) describes an example where the transmission module controller controls a carrier frequency of the transmission module. No relationship between redundant encoding processing and the carrier frequency is disclosed, however. The relationship between the redundant encoding processing and the carrier frequency would not be a matter that would be clear even without being disclosed. No relationship between redundant encoding processing and other control (a parameter other than the carrier frequency) of the transmission module is disclosed, either.

As such, the search was conducted with the understanding that the portion "transmission module controller that controls the transmission module in accordance with redundant encoding processing for converting to a multilevel sequence on the receiving side" of the invention in the claim refers to a "transmission module controller that controls the transmission module."

Form PCT/ISA/210 (extra sheet) (January 2015)

**EP 4 050 827 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4161883 B